Europäisches Patentamt

European Patent Office

Office européen des brevets

(19)

(11) Numéro de publication: **0 272 955 B1**

(12) **FASCICULE DE BREVET EUROPEEN**

(45) Date de publication de fascicule du brevet:
30.10.91

(51) Int. Cl.⁵: **H03K 17/693**

(21) Numéro de dépôt: 87402586.9

(22) Date de dépôt: 17.11.87

(54) **Circuit de commutation de tension en technologie MOS.**

(30) Priorité: 21.11.86 FR 8616256

(43) Date de publication de la demande:
29.06.88 Bulletin 88/26

(45) Mention de la délivrance du brevet:
30.10.91 Bulletin 91/44

(84) Etats contractants désignés:
DE ES FR GB IT

(56) Documents cités:
EP-A- 0 031 582
US-A- 4 023 050
US-A- 4 317 110

PATENT ABSTRACTS OF JAPAN, vol. 5, no.
186 (E-84)[858], 25 novembre 1981; & JP-A-56
111 320

(73) Titulaire: SGS-THOMSON MICROELECTRO-
NICS S.A.
7, Avenue Galliéni
F-94250 Gentilly(FR)

(72) Inventeur: Fruhauf, Serge
THOMSON-CSF SCPI 19, avenue de Messine
F-75008 Paris(FR)
Inventeur: Silvestre de Ferron, Gérard
THOMSON-CSF SCPI 19, avenue de Messine
F-75008 Paris(FR)

(74) Mandataire: Ballot, Paul Denis Jacques et al
Cabinet Ballot-Schmit 7, rue le Sueur
F-75116 Paris(FR)

## Description

La présente invention concerne un circuit de commutation de tension en technologie MOS. Elle concerne plus particulièrement un circuit de commutation de tension en technologie MOS délivrant en sortie, en fonction d'un signal de commutation, soit une première tension Vpp, soit une deuxième tension Vcc la tension Vpp étant supérieure à la tension Vcc.

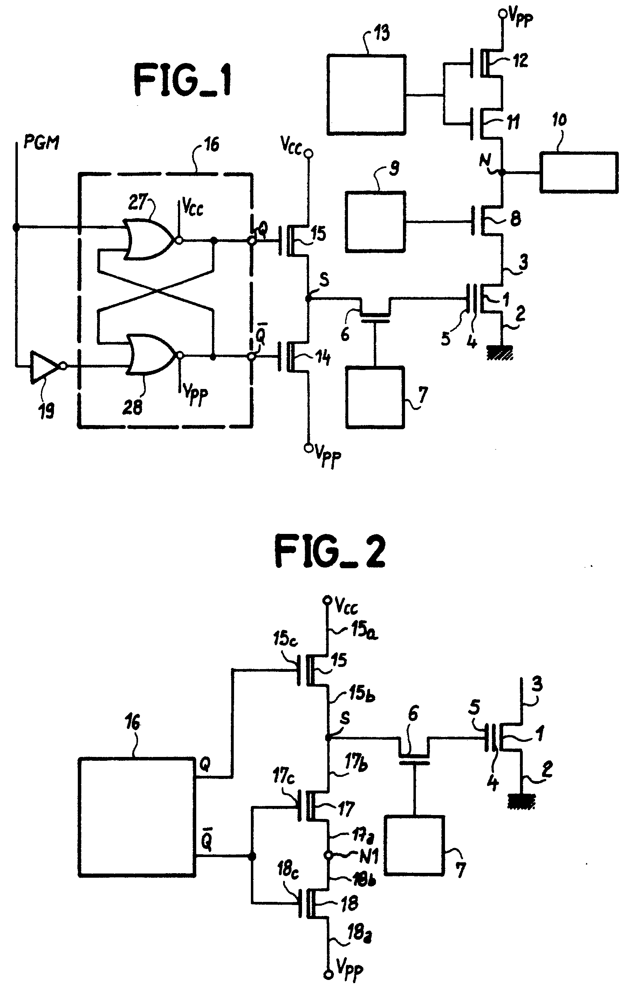

Ce type de circuit de commutation est utilisé notamment pour programmer ou lire des mémoires de type EPROM ou EEPROM dont la cellule-mémoire est constituée par un transistor NOS à grille flottante. Ainsi, comme représenté sur la figure 1 qui concerne une mémoire EPROM dont la cellule-mémoire 1 est constituée par un transistor à grille flottante de type SAMOS (pour stacked gate avalanche injection MOS), chaque transistor à grille flottante 1 comporte deux électrodes principales respectivement 2 et 3 et une grille de commande 5 empilée sur la grille flottante 4. Dans le cas d'une mémoire, les transistors à grille flottante 1 constituant les cellules-mémoire sont connectés sous forme matricielle. Ainsi, une première électrode principale 2 ou source, dans la technologie utilisée, est reliée à la masse tandis que l'autre électrode 3 ou drain est reliée par l'intermédiaire d'une ligne de bit non représentée et d'un transistor MOS formant interrupteur 8 à un décodeur d'adresse de colonne 9. La grille de commande 5 est reliée par l'intermédiaire d'une autre connexion dite ligne de mots non représentée à un décodeur d'adresse de ligne 7.

De manière plus spécifique, le décodeur d'adresse de colonne 9 est relié à la grille du transistor 8 dont la source est reliée à l'électrode 3 du transistor MOS 1 à grille flottante tandis que son autre électrode ou drain est reliée par l'intermédiaire d'une ligne de charge constituée des transistors MOS 11 et 12 à la tension de programmation Vpp. La ligne de charge est constituée d'un transistor MOS 12 déplété dont le drain est relié à Vpp et la source connectée au drain d'un transistor MOS 11 enrichi, les deux grilles des transistors 11 et 12 étant connectées ensemble et reliées à un circuit de commande d'écriture 13. D'autre part, le nœud N entre la source du transistor MOS 11 et le drain du transistor MOS 8 est connecté à un amplificateur de lecture représenté par le bloc 10.

De même, le décodeur d'adresse de ligne 7 est relié à la grille du transistor MOS interrupteur 6 dont l'une des électrodes principales est reliée à la grille de commande 5 du transistor MOS 1 à grille flottante tandis que son autre électrode principale est reliée à la sortie d'un circuit de commutation de tension.

Comme représenté sur la figure 1, le circuit de commutation de tension utilisé pour commuter la tension sur la sortie S, soit à la tension Vpp, soit à la tension Vcc, est constitué essentiellement de deux transistors MOS déplétés 14 et 15 montés entre la tension d'alimentation Vcc et la tension de programmation Vpp. De manière plus spécifique, le drain du transistor déplété 14 est connecté à Vpp. Sa source est connectée à la source du transistor déplété 15 dont le drain est connecté à la tension Vcc. La sortie du circuit de commutation est réalisée au point milieu S entre les deux transistors MOS déplétés 14 et 15. D'autre part, les grilles des deux transistors déplétés 14 et 15 sont connectées respectivement sur les sorties Q et Q d'une bascule RS 16. Cette bascule 16 est réalisée par exemple à l'aide de deux portes NI 27 et 28 entrecouplées, c'est-à-dire qu'une des entrées de la porte NI 27 est connectée à la sortie de la porte NI 28 et une des entrées de la porte NI 28 est connectée à la sortie de la porte NI 27. Par ailleurs, la porte NI 27 est alimentée à la tension d'alimentation Vcc tandis que la porte NI 28 est alimentée à la tension de programmation Vpp. Les autres entrées des portes NI 27 et 28 sont connectées respectivement au signal de commande de programmation PGM et au signal de commande de programmation inversé PGM obtenu en sortie de l'inverseur 19.

Pour lire une cellule-mémoire du type de celle représentée à la figure 1, une tension égale à la tension d'alimentation Vcc doit être appliquée sur la grille de commande 5. Cette tension provient du circuit de commutation. De ce fait, le signal sur la sortie S se trouve à la tension Vcc. Or, la tension d'alimentation Vcc est en général choisie égale à 5 volts, tandis que la tension de programmation Vpp est le plus souvent égale à 21 volts dans la technologie utilisée, mais doit pouvoir supporter des tensions au moins égales à 23 volts. Il en résulte que la tenue en tension du transistor MOS 14 doit être au moins égale à Vpp - Vcc, c'est-à-dire supérieure à 18 volts. Or, avec les technologies actuelles, il est difficile de réaliser des transistors MOS présentant une telle tenue en tension. De ce fait, on observe souvent un problème de claquage qui rend inutilisable le circuit de commutation.

La présente invention a donc pour but de remédier à cet inconvénient en proposant un nouveau circuit de commutation de tension en technologie MOS.

Ainsi, la présente invention a pour objet un circuit de commutation de tension en technologie MOS délivrant en sortie soit une première tension Vpp, soit une deuxième tension Vcc, en fonction d'un signal de commutation, la tension Vpp étant une haute tension supérieure à la tension Vcc, caractérisé an ce qu'il est constitué par un premier transistor MOS dont une des électrodes est reliée à la tension Vcc et par un groupe de deux transistors MOS de même type en série dont une des électrodes est reliée à la tension Vpp et les deux grilles sont connectées ensemble, de manière à créer un noeud flottant au point commun entre les deux transistors MOS, l'autre électrode du premier transistor MOS et l'autre électrode similaire du groupe de deux transistors MOS étant reliées ensemble et les grilles du premier transistor MOS et du groupe de deux transistors MOS recevant respectivement le signal de commutation et le signal de commutation inversé.

D'autres caractéristiques et avantages de la présente invention apparaîtront à la lecture de la description d'un mode de réalisation faite ci-après avec référence aux dessins ci-annexés dans lesquels :

- la figure 1 déjà décrite est une représentation schématique d'une mémoire non volatile programmable électriquement comportant un circuit de commutation de tension,
- la figure 2 est une représentation schématique d'un mode de réalisation du circuit de commutation de tension conforme à la présente invention.

Pour simplifier la description dans les figures les mêmes éléments portent les mêmes références. D'autre part, la description a été faite en se référant à une technologie NMOS et à un circuit de commutation réalisé à l'aide de transistors MOS déplétés, toutefois il est évident pour l'homme de l'art que la présente invention peut être réalisée dans d'autres technologies et avec d'autres types de transistors MOS, notamment des transistors MOS enrichis.

Comme représenté sur la figure 2, le circuit de commutation de tension conforme à la présente invention comporte à la place du transistor MOS déplété 14 relié à la tension Vpp un groupe de deux transistors MOS déplétés 17 et 18. De manière plus spécifique, le circuit de commutation de la présente invention est constitué du groupe de deux transistors MOS 18 et 17 connectés en série avec l'électrode 18a ou drain du transistor MOS 18 reliée à la tension de programmation Vpp et un transistor MOS déplété 15 dont l'électrode 15a ou drain est reliée à la tension d'alimentation Vcc, l'autre électrode ou source 15b du transistor MOS 15 étant reliée à l'électrode 17b ou source du transistor MOS déplété 17. D'autre part, le drain 17a du transistor 17 est connecté à la source 18b du transistor MOS 18 en donnant un noeud N1 flottant car les grilles 17c et 18c du groupe des deux transistors MOS sont reliées ensemble. De plus, les grilles 17c et 18c sont connectées à la sortie Q de la bascule 16 tandis que la grille 15c du transistor MOS 15 est reliée à la sortie Q de la bascule 16. De manière connue, la sortie S du circuit de commutation est reliée par l'intermédiaire d'un transistor MOS interrupteur 6 commandé par le décodeur d'adresse de ligne 7 à la grille de commande 5 d'un transistor MOS à grille flottante 1 constituant une cellule-mémoire d'une mémoire EPROM par exemple.

En expliquant ci-après le fonctionnement du circuit de commutation conforme à la présente invention, on en donnera aussi les avantages. Ainsi, en lecture, la sorti Q de la bascule RS se trouve être positionnée au niveau logique "1". De ce fait, le transistor MOS déplété 15 est passant et la tension au niveau du point S est positionnée à Vcc. En conséquence, le groupe des deux transistors MOS déplétés 18 et 17 doit avoir une tenue en tension au moins égale à Vpp - Vcc. Or, comme le noeud N1 entre les deux transistors MOS 18 et 17 est flottant, la tension au niveau de ce noeud s'ajuste automatiquement à Vpp - la tension de claquage du transistor MOS 18. De même, la tension au noeud N1 peut être égale à Vcc + la tension de claquage du transistor MOS déplété 17. En conséquence, le circuit de commutation ainsi réalisé permet de remonter la tension de claquage de l'ensemble. En effet, avec le circuit ci-dessus, Vpp peut être égal à Vcc + 2 tensions de claquage.

Un autre avantage du circuit de commutation de la présente invention réside dans le fait que l'on observe un phénomène de déroulement de jonction qui permet de reculer la tension de claquage et donc d'accroître la valeur de Vpp. En effet, lors du claquage, les charges piégées dans l'oxyde sont remplacées par des électrons qui vont rendre conducteur le transistor NPN parasite qui passe donc en résistance négative. Avec le circuit de la présente invention, le transistor 18 ayant sa source flottante voit le même phénomène, mais, dans ce cas, la source 18b capte les électrons et ne rend donc pas le transistor parasite conducteur. Comme le transistor 18 ne claque pas, on peut donc profiter du phénomène de déroulement de jonction.

Selon une autre caractéristique de la présente invention, les deux transistors MOS 17 et 18 peuvent présenter un rapport W/L identique ou différent. D'autre part, pour obtenir un circuit de commutation présentant les mêmes caractéristiques que le circuit de commutation de la figure 1, les transistors MOS et 18 doivent présenter une surface environ deux fois plus grande que la surface du transistor MOS 14.

De même, les transistors MOS 15, 17 et 18 peuvent être de même type comme dans le mode de réalisation représenté ou non.

**Revendications**

1. circuit de commutation de haute tension en technologie MOS délivrant en sortie soit une première tension Vpp, soit une deuxième tension Vcc en fonction d'un signal de commutation, la tension Vpp étant une haute tension supérieure à la tension Vcc, caractérisé en ce qu'il est constitué par un premier transistor MOS (15) dont une (15a) des électrodes est reliée à la tension Vcc et par un groupe de deux transistors MOS de même type (17, 18) en série dont une (18a) des électrodes est reliée à la tension Vpp et les deux grilles (17c, 18c) sont connectées ensemble, de manière à créer un noeud flottant au point commun (17a, 17b) entre les deux transistors MOS, l'autre électrode (15b) du premier transistor MOS et l'autre électrode (17b) du groupe de deux transistors MOS étant reliées ensemble et les grilles (15c, 17c, 18c) du premier transistor MOS et du groupe de deux transistors MOS recevant respectivement le signal de commutation (Q) et le signal de commutation inversé (Q̄).

2. circuit de commutation de tension selon la revendication 1, caractérisé en ce que la tension Vpp est égale à la tension Vcc plus la somme des tensions de claquage de deux transistors MOS (17, 18) montés en série.

3. circuit de commutation de tension selon l'une quelconque des revendications 1 et 2, caractérisé en ce que les trois transistors MOS (15, 17, 18) sont de même type.

4. circuit de commutation de tension selon l'une quelconque des revendications 1 et 2, caractérisé en ce que les trois transistors MOS (15, 17, 18) sont de type différents.

5. circuit de commutation de tension selon l'une quelconque des revendications 1 à 4, caractérisé en ce que les transistors MOS (17, 18) du groupe de deux transistors MOS présentent des rapports W/L identiques.

6. circuit de commutation de tension selon l'une quelconque - des revendications 1 à 4, caractérisé en ce que les transistors MOS (17, 18) du groupe de deux transistors MOS présentent des rapports W/L différents.

## Claims

1. A high voltage switching circuit manufactured in MOS technology supplying at the output either a first voltage Vpp or a second voltage Vcc as a function of a switching signal, the voltage Vpp being a high voltage above the voltage Vcc, characterized in that it is constituted by a first MOS transistor (15) of which one electrode (15a) is connected with the voltage Vcc and by a set of two MOS transistors of the same type (17 and 18) in series of which one (18a) of the electrodes is connected with the voltage Vpp and the two gates (17c and 18c) are connected together in such a manner as to produce a floating node at the common point (17a and 17b) between the two MOS transistors, the other electrode (15b) of the first MOS transistor and the other electrode (17b) of the set of two MOS transistors being connected together and the gates (15c, 17c and 18c) of the first MOS transistor and of the set of two MOS transistors respectively receiving the switching signal (Q) and the inverted switching signal (Q̄).

2. The voltage switching circuit as claimed in claim 1, characterized in that the voltage Vpp is equal to the voltage Vcc plus the sum of the breakdown voltages of the two MOS transistor (17 and 18) connected in series.

3. The voltage switching circuit as claimed in claim 1 or in claim 2, characterized in that the three MOS transistors (15, 17 and 18) are of the same type.

4. The voltage switch circuit as claimed in claim 1 or in claim 2, characterized in that the three MOS transistors (15, 17 and 18) are of different types.

5. The voltage switching circuit as claimed in any one of the preceding claims 1 through 4, characterized in that the MOS transistors (17 and 18) of the set of two MOS transistors present identical W/L ratios.

6. The voltage switching circuit as claimed in any one of the preceding claims 1 through 4, characterized in that the MOS transistors (17 and 18) of the set of two MOS transistors present different W/L ratios.

## Patentansprüche

1. Schaltung zum Umschalten einer hohen Spannung in MOS-Technologie, die an ihrem Ausgang in Abhängigkeit von einem Umschaltsignal entweder eine erste Spannung Vpp oder eine zweite Spannung Vcc liefert, wobei die Spannung Vpp eine hohe Spannung oberhalb der Spannung Vcc ist, dadurch gekennzeichnet, daß sie einen ersten MOS-Transistor (15), von dem eine (15a) seiner Elektroden mit der Spannung Vcc verbunden ist, und eine Gruppe von zwei in Reihe geschalteten MOS-Transistoren gleichen Typs (17, 18), von denen eine (18a) ihrer Elektroden mit der Spannung Vpp verbunden ist und deren zwei Gates (17c, 18c) so miteinander verbunden sind, daß im gemeinsamen Punkt (17a, 17b) zwischen den zwei MOS- Transistoren ein schwebender Knoten geschaffen wird, umfaßt, wobei die andere Elektrode (15b) des ersten MOS-Transistors und die andere Elektrode (17b) der Gruppe der zwei MOS- Transistoren miteinander verbunden sind und die Gates (15c, 17c, 18c) des ersten MOS-Transistors und der Gruppe der zwei MOS-Transistoren das Umschaltsignal (Q) bzw. das inverse Umschaltsignal ($\overline{Q}$) empfangen.

2.  Schaltung zum Umschalten einer Spannung gemäß Anspruch 1, dadurch gekennzeichnet, daß die Spannung Vpp gleich der Spannung Vcc plus der Summe der Durchbruchspannungen der zwei in Reihe geschalteten MOS-Transistoren (17, 18) ist.

3.  Schaltung zum Umschalten einer Spannung gemäß einem der Ansprüche 1 und 2, dadurch gekennzeichnet, daß die drei MOS-Transistoren (15, 17, 18) vom gleichen Typ sind.

4.  Schaltung zum Umschalten einer Spannung gemäß einem der Ansprüche 1 und 2, dadurch gekennzeichnet, daß die drei MOS-Transistoren (15, 17, 18) verschiedenen Typs sind.

5.  Schaltung zum Umschalten einer Spannung gemäß einem der Ansprüche 1 bis 4, dadurch gekennzeichnet, daß die MOS-Transistoren (17, 18) der Gruppe der zwei MOS-Transistoren identische W/L-Verhältnisse aufweisen.

6.  Schaltung zum Umschalten einer Spannung gemäß einem der Ansprüche 1 bis 4, dadurch gekennzeichnet, daß die MOS-Transistoren (17, 18) der Gruppe der zwei MOS-Transistoren verschiedene W/L-Verhältnisse aufweisen.

# FIG_1

# FIG_2